# EUROPEAN PATENT SPECIFICATION

(11) **EP 1 369 204 B1**
(45) Date of publication and mention of the grant of the patent: **11.10.2006**
(21) Application number: 03012509.0
(22) Date of filing: 02.06.2003
(51) Int. Cl.: B24D 13/12, B24D 13/14, B24B 37/04

(54) **Polishing pad and process for manufacturing a polishing pad**
Polierkissen und Verfahren zur Herstellung eines Polierkissens
Tampon de polissage et procédé de fabrication d'un tampon de polissage

(30) Priority: 03.06.2002 JP 2002162142; 28.06.2002 JP 2002191401; 28.06.2002 JP 2002191402; 28.06.2002 JP 2002191403
(43) Date of publication of application: 10.12.2003
(73) Proprietor: JSR Corporation, Tokyo 104-0045 (JP)
(72) Inventor: Kawahashi, Nobuo, Tokyo (JP); Hasegawa, Kuo, Tokyo (JP); Shiho, Hiroshi, Tokyo (JP); Koumura, Tomoo, Tokyo (JP); Kawahara, Kouji, Tokyo (JP); Hosaka, Yukio, Tokyo (JP)
(74) Representative: TBK-Patent

(56) References cited:
- EP-A- 0 878 270
- EP-A- 1 164 559
- WO-A-01/45899
- WO-A-01/91971
- US-A- 6 022 268
- PATENT ABSTRACTS OF JAPAN vol. 2000, no. 15, 6 April 2001 (2001-04-06) & JP 2000 349053 A (ASAHI CHEM IND CO LTD), 15 December 2000 (2000-12-15)

## Description

### BACKGROUND OF THE INVENTION

### FIELD OF THE INVENTION

The present invention relates to a polishing pad as per the preamble at claim 1. An example of such a polishing pad in disclosed in EP 0 878 270. In more detail, the invention relates to a polishing pad and a multi-layer polishing pad that have a groove having a specific shape on a polishing surface side, or a concave part having a specific shape that opens toward a polishing surface side. The polishing pad and the multi-layer polishing pad of the invention can be widely used in manufacture of semiconductor devices, and particularly preferably used in chemical mechanical polishing and the like of a surface of a material to be polished such as a wafer. The present invention relates furthermore to a process for manufacturing a polishing pad as per the preambles of claims 10 and 11.

### DESCRIPTION OF THE PRIOR ART

Recently, chemical mechanical polishing (CMP) attracts attention as a polishing method that allows forming a surface having excellent planarity. In the CMP, with a polishing pad and a surface to be polished of a material to be polished sliding, a slurry that is an aqueous dispersion therein abrasive is dispersed is flowed from upward onto a surface of the polishing pad, and thereby polishing is performed. In the CMP, it is known that a polishing result is largely influenced depending on a state and characteristics of the polishing pad.

Technique in which a removal rate and a polishing result can be improved by disposing a groove on a surface of the polishing pad is disclosed in JP-A H11-70463, H08-216029 and H08-39423. Even when the technique is used, however, in some cases, scratch cannot be sufficiently inhibited from being formed on a polished surface of a material to be polished.

Furthermore, a polishing pad that can form pores on a polishing surface of the polishing pad without using a foamed body, is disclosed in JP-W No.8-500622, JP-A 2000-34416, 2000-33552 and 2001-334455. Even when these techniques are used, however, in some cases, pores cannot be suppressed from being clogged by abrasive and polishing wastages during polishing, or pores cannot be suppressed from being clogged after dressing, and thereby, the removal rate cannot be sufficiently improved. Still furthermore, in some cases, the slurry cannot be sufficiently uniformly distributed on the polishing pad; accordingly, the removal rate cannot be sufficiently improved and a sufficiently uniform polished surface cannot be obtained.

WO 01 91971 describes polishing pads for chemical mechanical planarisation having a surface roughness of about 1 to about 9 µm and suitable mechanical properties wherein some of said pads comprise a grooved macrotexture to facilitate slurry transport.

WO 01 45899 discloses a polishing pad and a method and an apparatus for polishing, wherein said polishing pad is characterised by having a mechanism for supplying water to the plane of the polishing pad. Said mechanism comprises a domain structure and thereby reduces the generation of scratches and dust adhesion.

EP A 0878270 describes a polishing pad having a grooved pattern for use in a chemical mechanical polishing apparatus wherein said polishing pad includes a plurality of concentric circular grooves of different widths and soakings.

EP-A-1164559 discloses a composition for polishing pad and polishing pad using the same, wherein said polishing pad has an excellent slurry retaining property and a large removal rate.

US-A-6022268 describes polishing pads and methods relating thereto, wherein said pads have an hydrophilic polishing material and a surface topography and texture which generally improves predictability and polishing performance.

### SUMMARY OF THE INVENTION

The present invention intends to overcome the above existing problems and thereby to provide a polishing pad and a multi-layer polishing pad that can particularly effectively suppress scratch occurring.

The present invention provides a polishing pad as defined in claim 1 as well as a process for manufacturing a polishing pad as defined in claims 10 and 11.

Further developments of the claimed subject-matter and preferred embodiments are set forth in the dependent claims 2 to 9.

According to the polishing pad of the invention, by providing a groove (a) having a specific shape, a concave portion (b) and a through hole (c), scratches owing to foreign matters generated therein can be effectively suppressed from occurring, and polished surface is excellent in planarity.

In addition, when the groove (a) has a specific depth and width, the concave portion (b) a specific depth and minimum length of an opening, and the through hole (c) a specific minimum length of an opening, and furthermore when an area of one opening of the concave portion (b) and that of the through hole (c) are 0.0075 mm² or more, respectively, the scratch occurring can be more assuredly suppressed.

Furthermore, when minimum lengths between adjacent openings of the groove (a), the concave portion (b) and the through hole (c) are 0.05 mm or more, efficient polishing can be forwarded while the strength of a convex portion that corresponds to the polishing surface is maintaining.

When at least part of the polishing pad includes a water-insoluble matrix including a crosslinked polymer and a water-soluble particle, surface roughness of an inner surface of the groove (a), the concave portion (b) and the through hole (c) can be easily suppressed to 20 µm or less. Accordingly, the pores are not clogged by dressing, the slurry is sufficiently held and the removal rate can be made larger.

Furthermore, in case the groove (a), the concave portion (b) and the through hole (c) are formed with a method selected from cutting and molding, the surface roughness of the inner surface of each part can be easily made smaller, resulting in sufficiently suppressing the scratch from occurring.

According to the multi-layer polishing pad of an embodiment of the invention, the polishing can be efficiently forwarded without deforming a polishing layer during polishing. Furthermore, the scratch occurring due to the foreign matters generated in the groove and the like can be suppressed, and a polishing surface of the pad and a surface to be polished of a wafer or the like can be sufficiently brought into contact, accordingly, the removal rate can be improved.

### DETAILED DESCRIPTION OF THE INVENTION

In the following, the present invention will be detailed.

A polishing pad of the present invention comprises at least one part selected from the group consisting of a groove (a) having at least one kind of shape selected from annular, lattice-like and spiral form on a polishing surface side, a concave portion (b) and a through hole (c).

The surface roughness of an inner surface of a groove (a), a concave portion (b) and a through hole (c) provided to a polishing pad of the invention is 20 µm or less, preferably 15 µm or less, more preferably 10 µm or less and particularly 7µm or less. A lower limit thereof is normally 0.05 µm. When the surface roughness is 20 µm or less, the scratch occurred during polishing can be effectively inhibited from occurring. The surface roughness means an averaged value (Ra) given by the sum of the absolute values of all the areas above and below the mean line divided by the sampling length and is measured by a measurement method described below at least before the polishing pad of the invention is used.

That the surface roughness Ra of the inner surface of the groove (a), the concave portion (b) and the through hole (c) is 20 µm or less means that there is no large unevenness therein. When there is large unevenness, a particularly large convex portion (made of, for instance, cutting residue generated when the groove is formed) drops off during polishing, resulting in causing scratches. Furthermore, foreign matters formed from the dropped off convex portion by compressing or the like owing to a pressure and friction heat during polishing, foreign matters formed from the dropped off convex portion and polishing wastage, solid component in the slurry and the like by interacting to form foreign matters may occur the scratches in some cases. In addition, even during dressing, in some cases, the convex portion may drops off, resulting in the similar inconvenience.

When the surface roughness Ra is 20 µm or less, in addition to inhibiting the scratch from occurring, a function as the groove (a), the concave portion (b) and the through hole (c), a function of distributing the slurry on the polishing surface and a function of exhausting waste outside can be particularly efficiently exhibited.

The surface roughness Ra is an average value obtained by measuring individual average values of the surface roughness of different three viewing fields of a surface of a polishing pad before use, with a measuring apparatus that can measure the surface roughness, and by averaging three of the obtained average surface roughness. The measuring apparatus being used is not particularly limited, for instance, optical surface roughness measuring apparatus such as a three-dimensional surface structure analytic microscope, a scanning laser microscope, and an electron beam surface morphology analysis instrument, and contact surface roughness measuring apparatus such as a probe type surface roughness meter can be used.

The groove (a) exists on a polishing surface side of the polishing pad. The groove (a) has a function of retaining slurry supplied during polishing and more uniformly distributing the slurry on the polishing surface. In addition, it has a function as an exhaustion path that temporarily stays waste such as polishing wastage generated during polishing and used slurry, and exhausts the waste outside of the system.

The groove (a) may have any shape selected from the group consisting of an annular shape, a lattice-like shape and a spiral shape. The polishing pad of the present invention may have one of these separately or may have these in combination.

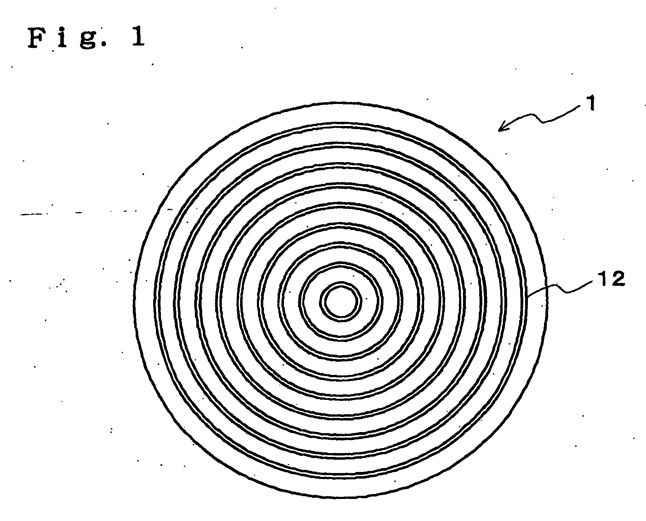

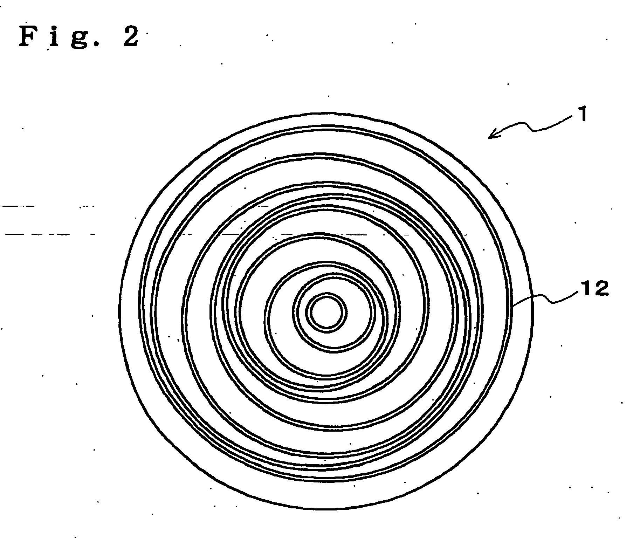

When the groove (a) is annularly formed, its planar shape is not particularly limited and the shape may be a circular, a polygonal (trigonal, tetragonal, pentagonal and the like), an elliptic and the like. The number of the grooves is preferably two or more. Furthermore, although arrangement of these grooves is not particularly limited, these may be, for instance, a concentrically arrangement (concentric circle-like and the like) with plural grooves 12 (Fig. 1), an eccentrically arrangement with plural grooves 12 (Fig. 2), or in such a way that a plurality of other annular grooves is arranged inside of a part surrounded by an annular groove. Among these, one in which plural grooves are concentrically arranged is preferable, and furthermore, one in which plural grooves are concentric circularly arranged (a state in which a plurality of circular grooves is concentrically arranged) is more preferable. The polishing pad having the concentric arrangement is superior to others in the above functions. In addition, the polishing pad having the concentric circular arrangement is more excellent in the above functions and the groove thereof can be easily formed.

On the other hand, a sectional shape of the groove is not particularly limited and may be, for instance, a shape formed of flat side surfaces and a bottom surface (the length of the respective width directions of an opening side and a bottom side may be the same, or the opening side may be longer in the length than the bottom side, or the bottom side may be longer in the length than the opening side), a horseshoe shape, a V-shape and the like.

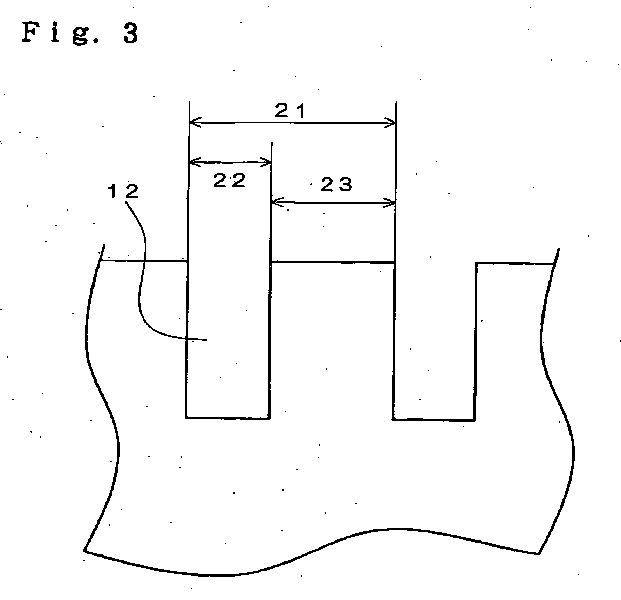

When the groove (a) is annularly formed, its magnitude is not particularly limited, and a width of the groove (22 in Fig. 3) is preferably 0.1 mm or more, more preferably in the range of from 0.1 to 5 mm, and further more preferably in the range of from 0.2 to 3 mm. The groove having a width less than 0.1 mm is formed in some cases with difficulty. On the other hand, a depth of the groove is preferably 0.1 mm or more, more preferably in the range of from 0.1 to 2.5 mm, and further more preferably in the range of from 0.2 to 2.0 mm. When the depth of the groove is less than 0.1 mm, it is not preferable because the lifetime of the polishing pad becomes excessively short. The depth of the groove may be different depending on positions.

In addition, a minimum length between adjacent grooves (23 in Fig. 3) is preferably 0.05 mm or more, more preferably in the range of from 0.05 to 100 mm, and more preferably from 0.1 to 10 mm. In some cases, it is difficult to form grooves having a minimum length between the adjacent grooves of less than 0.05 mm. Furthermore, a pitch (21 in Fig. 3) that is a sum of the width of the groove and a length of a portion between adjacent grooves is preferably 0.15 mm or more, more preferably in the range of from 0.15 to 105 mm, further more preferably from 0.3 to 13 mm, and particularly preferably from 0.5 to 2.2 mm.

Each of the preferable ranges can combine with other preferable ranges. That is, it is preferable, for instance, for the width to be 0.1 mm or more, for the depth 0.1 mm or more, and for the minimum length 0.05 mm or more; more preferable for the width to be in the range of from 0.1 mm to 5 mm, for the depth from 0.1 to 2.5 mm, and for the minimum length from 0.05 to 100 mm; and further more preferable for the width to be in the range of from 0.2 mm to 3 mm, for the depth from 0.2 to 2.0 mm, and for the minimum length from 0.1 to 10 mm.

The width and depth of the annular grooves formed on a polishing surface side of the polishing pad may be the same in the respective grooves or may be different.

When the groove (a) is formed in lattice, it may be formed of one continual groove or may be formed of two or more discontinuous grooves. Furthermore, a planar shape of one pattern that forms the lattice, not particularly limited, may be formed into various polygons. As the polygons, for instance, tetragons such as a square (Fig. 4), a rectangle, a trapezoid, and a lozenge (Fig. 5), a triangle (Fig. 6), a pentagon, and a hexagon can be cited. A sectional shape of the groove may be the same as that of the annular one.

When the groove (a) is formed in lattice, its magnitudes can be also the same as those of the annular one.

When a planar shape of one pattern that forms a lattice is a square, a minimum length between adjacent grooves (23 in Fig. 3) is preferably 0.05 mm or more, more preferably in the range of from 0.05 to 100 mm, and further more preferably from 0.1 to 10 mm. A lattice-like groove having the minimum length of less than 0.05 mm is in some cases formed with difficulty. Furthermore, a pitch that is a sum of the width of the groove and a length of a portion between adjacent grooves (21 in Fig. 3) is, in both of a vertical direction and a lateral direction, preferably 0.15 mm or more; more preferably in the range of from 0.15 to 105 mm, further more preferably from 0.3 to 13 mm, and particularly preferably from 0.5 to 2.2 mm. However, a pitch in the vertical direction and that in the lateral direction may be the same or different. Furthermore, when the tetragon is a lozenge, the shorter one of lengths of two pairs of parallel sides that face each other is taken as the minimum length.

Each of the preferable ranges of the magnitudes of the groove can combine with other preferable ranges. That is, it is preferable, for instance, for the width to be 0.1 mm or more, for the depth 0.1 mm or more, and for the minimum length 0.05 mm or more; more preferable for the width to be in the range of from 0.1 mm to 5 mm, for the depth from 0.1 to 2.5 mm, and for the minimum length from 0.05 to 100 mm; and further more preferable for the width to be in the range of from 0.2 mm to 3 mm, for the depth from 0.2 to 2.0 mm, and for the minimum length from 0.1 to 10 mm.

Furthermore, when a planar shape of one pattern that forms a lattice is a triangle, a length of the smallest side of the triangle is preferably 0.05 mm or more, more preferably in the range of from 0.05 to 100 mm, and further more preferably from 0.1 to 10 mm. When a length of the smallest side is less than 0.05 mm, a lattice-like groove can be in some cases formed with difficulty.

Each of the preferable ranges of the magnitudes of the groove can combine with other preferable ranges. That is, it is preferable, for instance, for the width to be 0.1 mm or more, for the depth 0.1 mm or more, and for the length of the smallest side 0.05 mm or more; more preferable for the width to be in the range of from 0.1 mm to 5 mm, for the depth from 0.1 to 2.5 mm, and for the length of the smallest side from 0.05 to 100 mm; and further more preferable for the width to be in the range of from 0.2 mm to 3 mm, for the depth from 0.2 to 2.0 mm, and for the length of the smallest side from 0.1 to 10 mm.

In addition, when a planar shape of one pattern that forms a lattice is a hexagon, a minimum length that is the shortest of parallel sides that face each other is preferably 0.05 mm or more, more preferably in the range of from 0.05 to 100 mm, and further more preferably from 0.1 to 10 mm. A lattice-like groove whose minimum length is less than 0.05 mm is in some cases formed with difficulty.

Each of the preferable ranges can combine with other preferable ranges. That is, it is preferable, for instance, for the width to be 0.1 mm or more, for the depth 0.1 mm or more, and for the smallest length 0.05 mm or more; more preferable for the width to be in the range of from 0.1 mm to 5 mm, for the depth from 0.1 to 2.5 mm, and for the smallest length from 0.05 to 100 mm; and further more preferable for the width to be in the range of from 0.2 mm to 3 mm, for the depth from 0.2 to 2.0 mm, and for the smallest length from 0.1 to 10 mm.

The lattice-like grooves formed on a polishing surface side of the polishing pad may be formed of one kind of grooves the same in the width and depth, respectively, or may be formed of a combination of two or more kinds of grooves different in the width and the depth. Furthermore, the polishing surface may be provided thereon with only one kind of lattice-like grooves the same in a planar shape of one pattern that forms the lattice, or may be provided with two or more kinds of lattice-like grooves different in the planar shape.

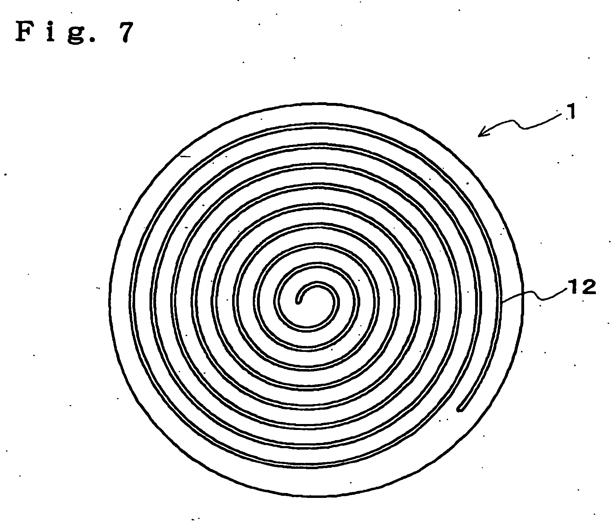

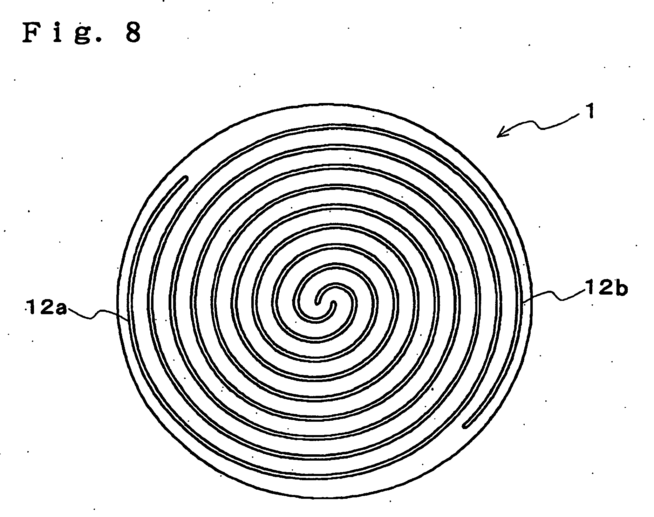

When the groove (a) is spirally formed, it may be formed of one continuous groove 12 (Fig. 7), or may be formed of two spiral grooves 12a and 12b whose spiral directions are different each other (Fig. 8). Furthermore, it may be formed of two spiral grooves whose spiral directions are the same, or may be formed of three or more spiral grooves whose spiral directions are the same each other or different from each other. A sectional shape of the groove may be the same as that of the annular one. And when the groove (a) is spirally formed, its magnitudes can be the same as those of the annular one. In addition, a minimum length between adjacent grooves and a pitch can be also the same as those of the annular one.

The width and depth of the spiral groove formed on the polishing surface side of the polishing pad may be the same over all length or different. Furthermore, when two or more grooves are formed, the width and the depth of the respective grooves may be the same or different.

The "concave portion (b)" exists on a polishing surface side of the polishing pad. Furthermore, the "through hole (c)" is opened toward both surfaces of the polishing surface and a surface opposite to the polishing surface. The concave portion (b) or the through hole (c) (hereinafter, in some cases, referred to as "concave portion and the like") has a function of retaining the slurry supplied during polishing and more uniformly distributing the slurry on the polishing surface. Furthermore, the concave portion and the like has a function of an exhaustion path that allows waste such as polishing wastage generated during polishing and used slurry to temporarily stay and exhausts the waste outside of the system. Even when the polishing pad has the through holes, by fixing the polishing pad to a surface plate of polishing apparatus owing to depression or the like, the slurry does not outflow through the through holes without serving to polishing.

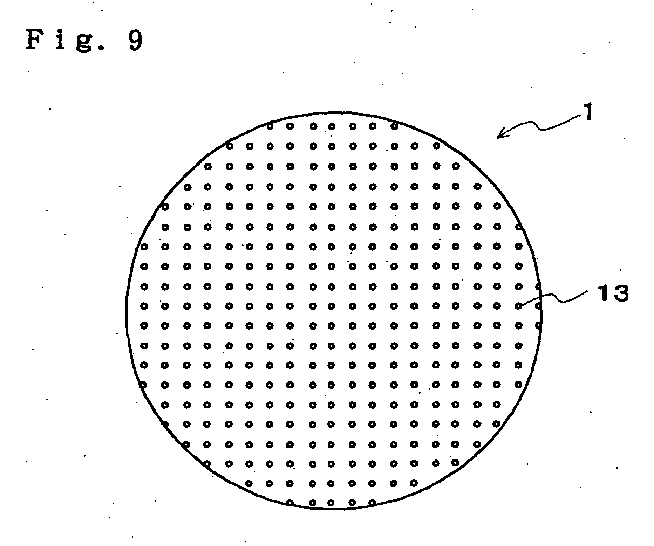

A planar shape of the concave portions and the like is not particularly limited, but may be, for instance, a circle, a polygon (trigon, tetragon, pentagon and the like), an ellipse and the like. An arrangement of openings of the concave portions and the like on the polishing surface is neither limited, but the openings are preferable to be uniformly arranged over an entire surface of the polishing surface. As a specific example of the polishing pad that has the concave portions or the like, one in which on the polishing surface thereof the concave portions 13 and the like having a circular planar shape are uniformly opened (Fig. 9) can be cited. A sectional shape of the concave portions or the like is not particularly limited, but may be, for instance, one formed of flat side surfaces and bottom surface (In the case of the concave portion, the length of the respective horizontal sectional directions of an opening side and a bottom side may be the same, or the opening side may be longer in the length than the bottom side, or the bottom side may be longer in the length than the opening side. Furthermore, in the case of the through hole, length of the respective horizontal directions of one opening side and the other opening side may be the same, or the length of the polishing surface side may be longer, or the length of the opposite surface side may be longer.), a horseshoe shape, a V-shape, and the like.

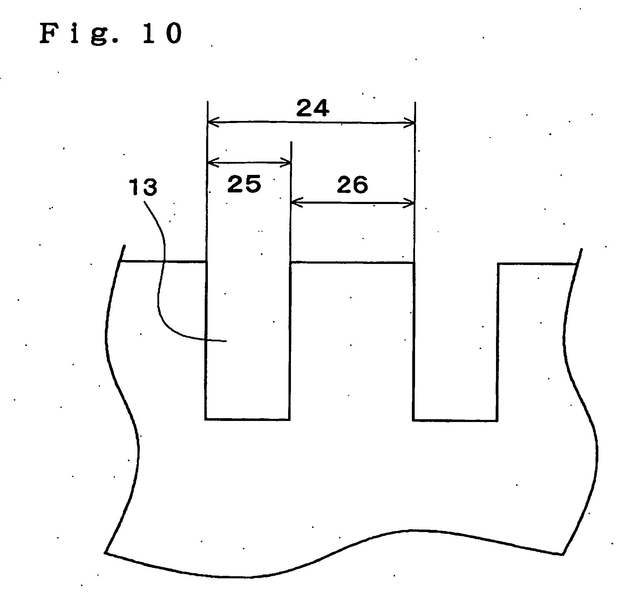

The magnitude of the concave portions or the like is not particularly limited, but it may be, when the planar shape is, for instance, circular one, a diameter thereof, and when the planar shape is at least one selected from a polygon, an ellipse and the like, the minimum length of the opening (25 in Fig. 10) is preferably 0.1 mm or more, more preferably in the range of from 0.1 to 5 mm, and further more preferably from 0.2 to 3 mm. Usually, it tends to be difficult to form the concave portion or the like whose diameter or the minimum length is less than 0.1 mm. Furthermore, the depth of the concave portion or the like is preferably 0.1 mm or more, more preferably in the range of from 0.1 to 2.5 mm, and further more preferably from 0.2 to 2.0 mm. The depth of the concave portion or the like being less than 0.1 mm is not preferable because the excessively short lifetime of the polishing pad results. Still furthermore, for a separation of the concave portions or the like, the smallest length between adjacent concave portions or the like (26 in Fig. 10) is preferably 0.05 mm or more, more preferably in the range of from 0.05 to 100 mm, and further more preferably from 0.1 to 10 mm. It also tends to be difficult to form the concave portion or the like whose smallest length is less than 0.05 mm. Furthermore, a pitch that is a sum of the minimum length of the opening of the concave portion or the like and a length of a portion between adjacent concave portions or the like (26 in Fig. 10) is preferably 0.15 mm or more, more preferably in the range of from 0.15 to 105 mm, further more preferably from 0.3 to 13 mm, and particularly from 0.5 to 2.2 mm.

Each of the preferable ranges can combine with other preferable ranges. That is, it is preferable, for instance, for the minimum length of the opening to be 0.1 mm or more, for the depth 0.1 mm or more, and for the smallest length between the adjacent concave portions or the like 0.05 mm or more; more preferable for the minimum length of the opening to be in the range of from 0.1 mm to 5 mm, for the depth from 0.1 to 2.5 mm, and for the smallest length between the concave portions or the like from 0.05 to 100 mm; and further more preferable for the minimum length in a planar direction to be in the range of from 0.2 mm to 3 mm, for the depth from 0.2 to 2.0 mm, and for the smallest length between the adjacent concave portions or the like from 0.1 to 10 mm.

The concave portion (b) is 0.0075 mm² or more in an area of an opening at the surface of the polishing pad, more preferably 0.01 mm², further more preferably 1 mm² or more, and normally 100 mm² or less. Since the area of the opening is 0.0075 mm² or more, the slurry supplied during polishing can be sufficiently retained, and waste such as the polishing wastage that is generated owing to the polishing and the used slurry can be allowed to temporarily stay and can be easily exhausted outside.

The planar shapes, the minimum length of the opening, and the depths of the concave portions or the like opened toward the polishing surface side and the like may be same or may be varied. In addition, the concave portions or the like may be formed with a uniform separation over an entire polishing surface, or may not be uniformly formed; however, in order to stably perform the polishing, these are preferably uniformly formed. The polishing pad of the invention can comprise a groove having a various shape described above in addition to the concave portions or the like.

The polishing pad of the invention may be formed of whatever materials as far as the functions as the polishing pad can be exhibited. However, among the functions as the polishing pad, particularly, it is preferable for pores that has a function of retaining the slurry during polishing and allowing the wastage to temporarily stay to have been formed up to the time of polishing. Accordingly, the polishing pad is preferably provided with a water-insoluble matrix and a water-soluble particle dispersed in the water-insoluble matrix, or with a water-insoluble matrix therein vacancies are dispersingly formed (foamed body and the like).

Of these, in the former, the water-soluble particles are brought into contact with a water-based medium component of the slurry (containing a medium component and a solid component) during polishing, dissolve or swell, resulting in dropping-off. The slurry is retained in the pores formed because of the dropping-off. On the other hand, in the latter, the slurry is retained in the pores previously formed as the vacancies.

A material that constitutes the "water-insoluble matrix" is not particularly limited. In view of being easy to mold into a predetermined shape, property and state, and being capable of endowing appropriate hardness and appropriate elasticity, it is usual to use an organic material. As the organic material, thermoplastic resins, elastomers, rubbers (crosslinked rubbers) and curable resins (resins cured owing to heat, light and the like such as thermo-setting resins and photo-setting resins) can be used alone or in combination.

Among these, as the thermoplastic resins, 1,2-polybutadiene resin, polyolefinic resins such as polyethylene, polystyrene-based resins, polyacrylic resins such as (meth)acrylate-based resins, vinylester-based resins (except for acrylic-based resins), polyester-based resins, polyamide-based resins, fluorinated resins such as polyvinylidene fluoride, polycarbonate resins and polyacetal resins can be cited.

As the elastomers, diene-based elastomers such as 1,2-polybutadiene, polyolefinic elastomers (TPO), styrene-based elastomers such as styrene-butadiene-styrene block copolymers (SBS) and hydrogenated block copolymers thereof (SEBS), thermoplastic elastomers such as thermoplastic polyurethane-based elastomers (TPU), thermoplastic polyester-based elastomers (TPEE), and polyamide-based elastomers (TPAE), silicone resin-based elastomers, fluorinated resin-based elastomers and the like can be cited.

As the rubbers, conjugated diene-based rubbers such as butadiene-based rubbers (high-cis butadiene rubber, low-cis butadiene rubber and the like), isoprene-based rubbers, styrene-butadiene-based rubbers and styrene-isoprene-based rubbers, nitrile-based rubbers such as acrylonitrile-butadiene-based rubbers and the like, acrylic rubbers, ethylene-α-olefin-based rubbers such as ethylene-propylene-based rubbers, ethylene-propylene-diene-based rubbers, and other rubbers such as butyl rubbers, silicone rubbers and fluororubbers can be cited.

As the curable resins, urethane-based resins, epoxy-based resins, acrylic resins, unsaturated polyester-based resins, polyurethane-urea-based resins, urea-based resins, silicone-based resins, phenol-based resins, vinylester-based and the like resin can be cited.

Furthermore, the organic material may be modified with an acid anhydride group, a carboxyl group, a hydroxyl group, an epoxy group, an amino group and the like. By modifying, the organic material can be controlled in its affinity with the water-soluble particles and the slurry.

The organic materials above can be used alone or in combinations of two or more kinds.

Furthermore, the organic material may be a crosslinked polymer that is partially or entirely crosslinked, or may be a non-crosslinked polymer. Accordingly, the water-insoluble matrix may be formed of a crosslinked polymer alone, a mixture of a crosslinked polymer and a non-crosslinked polymer, or a non-crosslinked polymer alone. However, it is preferable to contain the crosslinked polymer (the crosslinked polymer alone, or the mixture of the crosslinked polymer and the non-crosslinked polymer). When the crosslinked polymer is contained, surface roughness Ra of the inner surface of the groove (a), the concave portion (b) and the through hole (c) can be easily suppressed to 20 µm or less, and, at the same time, the water-insoluble matrix is endowed with an elastic recovering force; accordingly, a displacement due to the shearing-stress applied on the polishing pad during polishing can be suppressed small. Furthermore, the water-insoluble matrix can be effectively suppressed from being excessively elongated and plastic-deformed to bury the pores during polishing and dressing, and furthermore, a surface of the polishing pad can be effectively suppressed from becoming excessively fluffy. Accordingly, even during dressing, the pores can be effectively formed, and the slurry retaining power during polishing can be inhibited from deteriorating. Furthermore, since the surface of the polishing pad is less fluffy, the polishing flatness is not disturbed. A method of the crosslinking is not particularly limited; that is, chemical crosslinking with organic peroxide, sulfur, and sulfur compounds, radiation crosslinking due to electron beam or the like can be applied.

As the crosslinked polymer, among the organic material above, crosslinked rubbers, curable rubbers, crosslinked thermoplastic resins and crosslinked elastomers can be used. Among these, in view of being stable to strong acids and strong alkalis contained in many slurries and being less in the softening due to water absorption, one or both of the crosslinked thermoplastic resins and crosslinked elastomers are preferable. Furthermore, among the crosslinked thermoplastic resins and crosslinked elastomers, ones that are crosslinked with organic peroxide are particularly preferable, and furthermore crosslinked 1,2-polybutadiene is more preferable. With these, the groove (a), the concave portion (b) and the through hole (c) whose surface roughness Ra is 20 µm or less can be easily formed.

A content of the crosslinked polymer is not particularly limited. It is preferably contained by 30 % by volume or more, more preferably 50 % by volume or more, further more preferably 70 % by volume or more, and may be 100 % by volume relative to an entirety of the water-insoluble matrix. When the content of the crosslinked polymer in the water-insoluble matrix is less than 30 % by volume, in some cases, an effect of containing the crosslinked polymer cannot be sufficiently exhibited.

The water-insoluble matrix containing the crosslinked polymer, when a specimen made of the water-insoluble matrix is broken at 80 °C according to JIS K 6251, can make the elongation that remains after the breaking (hereinafter, simply referred to as "elongation remaining after breaking") 100 % or less. That is, a total length between markers after the breaking is two times or less a length between markers before the breaking. The elongation remaining after breaking is preferably 30 % or less, more preferably 10 % or less, particularly preferably 5 % or less, and normally 0 % more. When the elongation remaining after breaking exceeds 100 %, fine fragments scraped or stretched out from a surface of the polishing pad during polishing or dressing unfavorably tend to clog the pores. When, according to JIS K 6251 "Elongation Test Method of Vulcanized Rubber", with a test sample having a shape--of dumbbell No. 3, and under the conditions of a pulling rate of 500 mm/min and a test temperature of 80 °C, a test sample is broken, the " elongation remaining after breaking" is defined as an elongation rate of a length that is obtained by subtracting a length between markers before the test from a total length of the respective lengths from the markers to the broken portion of the test sample that are separated by the breaking to the length between markers before the test. Furthermore, in actual polishing, there is heat generation due to the sliding; accordingly, the test is carried out at 80 °C.

The "water-soluble particle" is a particle that drops off from the water-insoluble matrix when the polishing pad comes into contact, in the polishing pad, with the slurry that is an aqueous dispersion. The dropping-off may be caused by dissolving when the water-soluble particles come into contact with water or the like contained in the slurry, or may be caused by swelling and becoming gel-like when the water-soluble particles contain water and the like. Furthermore, the dissolution or the swelling may be caused not only by contact with water but also with an aqueous mixture medium containing an alcoholic solvent such as methanol.

The water-soluble particles have, other than the effect of forming the pores, in the polishing pad, another effect of making the indentation hardness of the polishing pad larger and thereby making an amount of indentation of the material to be polished due to the depression smaller. That is, when the polishing pad according to the invention contains the water-soluble particles, the Shore D hardness thereof can be made preferably 35 or more, more preferably in the range of from 50 to 90, further more preferably from 60 to 85, and usually 100 or less. When the Shore D hardness is 35 or more, a pressure that can be applied on the material to be polished can be made larger, and accompanying this, the removal rate can be improved. In further addition to this, the high polishing flatness can be obtained. Accordingly, the water-soluble particles are particularly preferable to be solid body that can secure sufficient indentation hardness in the polishing pad.

A material that constitutes the water-soluble particle is not particularly limited. And an organic water-soluble particle and an inorganic water-soluble particle can be cited. As the organic water-soluble particle, one that is made of saccharides (polysaccharides such as starch, dextrin and cyclodextrin, lactose, mannite and the like), celluloses (hydroxypropyl cellulose, methyl cellulose and the like), proteins, polyvinyl alcohol, polyvinyl pyrrolidone, polyacrylic acids and their salts, polyethylene oxide, water-soluble photosensitive resins, sulfonated polyisoprene, sulfonated polyisoprene copolymers and the like can be cited. In addition, as the inorganic water-soluble particle, one made of potassium acetate, potassium nitrate, potassium carbonate, potassium hydrogen carbonate, potassium chloride, potassium bromide, potassium phosphate, magnesium nitrate and the like can be cited. The material constituting water-soluble particles may be used alone or in combination of two or more kinds. Furthermore, the water-soluble particles may be one kind of water-soluble particles made of a predetermined material or two or more kinds of water-soluble particles made of different materials.

An average particle diameter of the water-soluble particle is preferably in the range of from 0.1 to 500 µm, more preferably from 0.5 to 100 µm, and further more preferably from 1 to 50 µm. That is, the magnitude of the pores is preferably in the range of from 0.1 to 500 µm, more preferably from 0.5 to 100 µm, and further more preferably from 1 to 50 µm. When the average particle diameter of the water-soluble particle is less than 0.1 µm, the magnitude of the formed pores becomes smaller than the abrasive to be used; accordingly, the polishing pad that can sufficiently retain the slurry becomes difficult to obtain. On the other hand, when the average particle diameter exceeds 500 µm, the magnitude of the pores to be formed becomes excessively large; as a result, the mechanical strength and the removal rate of the obtained polishing pad tend to deteriorate.

The water-soluble particle may not be contained. A content of the water-soluble particles in using is preferably in the range of from 0.1 to 90 % by volume, more preferably in the range of from 10 to 60 % by volume, and further more preferably from 20 to 40 % by volume based on 100 % by volume of a total of the water-insoluble matrix and the water-soluble particle. When the content of the water-soluble particle is less than 0.1 % by volume, the pores formed using the obtained polishing pad cannot be not be sufficient, and the removal rate tends to decrease. On the other hand, when the water-soluble particles are contained exceeding 90 % by volume, it tends to be difficult to sufficiently inhibit the water-soluble particle present within the polishing pad from swelling or dissolving; accordingly, it becomes difficult to maintain the hardness and the mechanical strength of the polishing pad at proper values.

Furthermore, the water-soluble particles are preferable to be dissolved in water only when exposed on a surface layer in the polishing pad, and not to absorb moisture and further swell when being within the polishing pad. Accordingly, at least part of the outermost part of the water-soluble particle may be provided with an outer shell that can suppress the moisture absorption. The outer shell may be physically absorbed by the water-soluble particle, or may form a chemical bond with the water-soluble particle, or may come into contact with the water-soluble particle through both of the above. As a material that constitutes such outer shell, epoxy resin, polyimide, polyamide, polysilicate and the like can be cited. The outer shell, even when only part of the water-soluble particle is provided therewith, can exhibit sufficiently the effect.

The water-insoluble matrix, in order to control affinity with the water-soluble particles and the dispersion properties of the water-soluble particles in the water-insoluble matrix, may contain a compatibilizing agent. As the compatibilizing agent, a polymer that is modified by an acid anhydride group, carboxyl group, hydroxyl group, epoxy group, oxazoline group, amino group and the like, a block copolymer, a random copolymer, furthermore, various kinds of a nonionic surfactant, a coupling agent and the like can be cited.

Furthermore, the water-insoluble matrix can contain, other than the compatibilizing agent, one kind or two or more kinds of abrasive, oxidizer, hydroxide of alkali metal, acid, pH controller, surfactant and anti-scratch agent that have been so far contained. Still furthermore, the water-insoluble matrix may contain a salt that forms an acid when used. Thereby, by supplying water alone, the polishing can be carried out.

As the abrasive, particles made of silica, alumina, ceria, zirconia, titania and the like can be cited. One kind or two or more kinds of these can be used.

As the oxidizer, hydrogen peroxide, peracetic acid, perbenzoic acid, organic peroxides such as tert-butyl hydroperoxide, permanganates such as potassium permanganate, dichromates such as potassium dichromate, halogen acid compounds such as potassium iodate, nitrates such as nitric acid and iron nitrate, perhalogen acid compounds such as perchloric acid, persulfate such as ammonium persulfate, heteropolyacids and the like can be cited. Among these oxidizers, other than hydrogen peroxide and organic peroxides whose decomposition products are not harmful, persulfate such as ammonium persulfate is particularly preferable. One kind or two or more kinds thereof can be used.

As the hydroxide of alkali metals, sodium hydroxide, potassium hydroxide, rubidium hydroxide, cesium hydroxide and the like can be cited. One kind or two or more kinds of these can be used.

As the acid, an organic acid and an inorganic acid can be cited. Among these, as the organic acid, para-toluene sulfonic acid, dodecyl-benzene sulfonic acid, isoprene sulfonic acid, gluconic acid, lactic acid, citric acid, tartaric acid, malic acid, glycolic acid, malonic acid, formic acid, oxalic acid, succinic acid, fumaric acid, maleic acid, phthalic acid and the like can be cited. Furthermore, as the inorganic acid, nitric acid, hydrochloric acid, sulfuric acid and the like can be cited. One kind or two or more kinds of these can be used.

As the salt, ammonium salts, alkali metal salts such as sodium salts and potassium salts, and alkali earth metal salts such as calcium salts and magnesium salts of the above acids can be cited. One kind or two or more kinds of these can be used.

As the surfactant, a cationic surfactant, an anionic surfactant and the like can be cited. Of these, as the anionic surfactant, carboxylates such as fatty acid soaps and alkyl ether carboxylate, sulfonates such as alkyl benzene sulfonates, alkyl naphthalene sulfonates and α-olefin sulfonates, sulfuric ester salts such as sulfuric ester salt of higher alcohol, alkyl ether sulfates, polyoxyethylene alkylphenyl ether sulfates, and phosphoric ester salts such as alkyl phosphoric ester salt and the like can be cited. One kind or two or more kinds of these can be used.

As the anti-scratch agent, bisphenol, bipyridyl, 2-vinylpyridine, 4- vinylpyridine, salicylaldoxime, o-phenylenediamine, m-phenylenediamine, catechol, o-aminophenol, thiourea, N-alkyl group-containing (meth)acrylamide, N-aminoalkyl group-containing (meth)acrylamide, 7-hydroxy-5-methyl-1,3,4-triazaindolizine, 5-methyl-1H-benzotriazole, phthalazine, melamine, 3-amino-5,6-dimethyl-1,2,4-triazine and the like can be cited. One kind or two or more kinds of these can be used.

Furthermore, the water-insoluble matrix can contain, other than the compatibilizing agent and the various kinds of materials that have been so far contained in the slurry, various kinds of additives such as a filler, softener, anti-oxidizer, UV-absorber, anti-static agent, lubricant and plasticizer. Among these, as a material constituting the filler, materials that can improve the rigidity such as calcium carbonate, magnesium carbonate, talc and clay, and materials that have polishing effect such as silica, alumina, ceria, zirconia, titanium oxide, manganese dioxide, manganese sesquioxide, and barium carbonate may be used.

A shape of the polishing pad of the invention is not particularly limited, and can be formed into, for instance, a disc-like one, a belt-like one, and a roller-like one; it is preferable to appropriately select according to polishing apparatus. In addition, a magnitude of the polishing pad before polishing is not particularly limited and in case of using a disc-like polishing pad, for instance, a diameter can be formed in the range of from 0.5 to 500 cm, more preferably in the range of from 1.0 to 250 cm, and particularly preferably from 20 to 200 cm, and a thickness can be made more than 0.1 mm and 100 mm or less, particularly in the range of from 1 to 10 mm.

Neither a manufacturing method of the polishing pad of the invention nor a method for forming a grove (a), a concave portion (b) and a through hole (c) that the polishing pad has is particularly limited. For instance, a composition for polishing pad that becomes a polishing pad is obtained in advance; the composition is formed into a desired rough shape; and thereafter, the groove (a), the concave portion (b) and the through hole (c) can be formed according to the cutting. Furthermore, when the composition is molded with a die on which a pattern that becomes a groove (a), a concave portion (b) and a through hole (c) is formed, a rough shape of the polishing pad and the groove (a), the concave portion (b) and the through hole (c) can be simultaneously formed. Still furthermore, these cutting and die molding may be in combination. According to the cutting and the die molding, surface roughness Ra of an inner surface of the groove (a), the concave portion (b) and the through hole (c) can be easily made 20 µm or less. When the polishing pad is one in which vacancies are dispersed in the water-insoluble matrix such as a foamed body, in the die molding, normally, a skin layer is formed on a surface, and the pores are not formed; accordingly, it cannot be used as a polishing pad.

A method of obtaining the composition for polishing pad is not particularly limited. It can be obtained by, for instance, kneading necessary materials such as predetermined organic materials by use of a kneading machine. As the kneading machine, one that has been known can be used. For instance, the kneading machine such as a roller, a kneader, Banbary mixer, an extruder (single shaft, multi-shaft) and the like can be cited.

The composition that contains the water-soluble particle can be obtained by kneading, for instance, the water-insoluble matrix, the water-soluble particle and other additives. In order to allow easily working at kneading, these materials are usually heated and kneaded. At a temperature at that time, the water-soluble particle is preferably solid. When the water-soluble particle is solid, irrespective of a magnitude of the compatibility with the water-insoluble matrix, these can be dispersed with the preferable average diameter. Accordingly, it is preferable to select, in accordance with a working temperature of the water-insoluble matrix to be used, a kind of the water-soluble particle.

A multi-layer polishing pad according to an embodiment of the present invention comprises a polishing layer comprising at least one part selected from the group consisting of a groove (a) having at least one kind of shape selected from annular, lattice-like and spiral form on a polishing surface side, a concave portion (b) and a through hole (c), in which the surface roughness Ra of an inner surface of the part is 20 µm or less, and a supporting layer laminated on a non-polishing surface side of the polishing layer.

As modes of the present multi-layer polishing pad, (1) one provided with a polishing layer that includes only a groove (a) having at least one shape selected from an annular, a lattice-like and a spiral and whose inner surface has the surface roughness Ra of 20 µm or less, and a supporting layer disposed on a non-polishing surface side of the polishing layer, (2) one provided with a polishing layer that includes only a concave portion (b) whose inner surface has the surface roughness Ra of 20 µm or less, and a supporting layer disposed on a non-polishing surface side of the polishing layer, (3) one provided with a polishing layer that includes only a through hole (c) whose inner surface has the surface roughness Ra of 20 µm or less, and a supporting layer disposed on a non-polishing surface side of the polishing layer, and (4) one provided with a polishing layer that includes at least two portions selected from a groove (a), a concave portion (b) and a through hole (c) whose inner surfaces have the surface roughness Ra of 20 µm or less, and a supporting layer disposed on a non-polishing surface side of the polishing layer, and the like can be cited.

As the polishing layer of the multi-layer polishing pad, the polishing pad of the invention above can be applied.

The supporting layer is a layer that supports the polishing layer and the like on a non-polishing surface side of the polishing layer. The supporting layer is not particularly limited in the characteristics, and it is preferable to be softer than the polishing layer. When the supporting layer is made softer, even when a thickness of the polishing layer is thin (for instance, 5 mm or less), the polishing layer is inhibited from rising or a surface of the polishing layer from curving during polishing; resulting in stable polishing. The hardness of the supporting layer is preferably 90 % or less of that of the polishing layer, more preferably 80 % or less, particularly 70 % or less, and normally 10 % or more.

Furthermore, the Shore D hardness is preferably 70 or less (more preferably 60 or less, and further more preferably 50 or less).

In addition, the supporting layer may be a porous body (foamed body) or a non-porous body. Furthermore, its planar shape is not particularly limited, and may be the same as the polishing layer or different from the polishing layer. As a planar shape of the supporting layer, for instance, a circle, a polygon (tetragon and the like) and the like can be adopted. Furthermore, a thickness of the supporting layer is neither particularly limited, but it can be made, for instance, in the range of from 0.1 to 5 mm, more preferably in the range of from 0.5 to 2 mm.

A material that constitutes the supporting layer is not particularly limited. In view of easiness to form a predetermined shape and state and capability of endowing appropriate elasticity, an organic material is preferably used. As the organic material, the organic materials that constitute the water-insoluble matrix in the polishing pad above can be applied. However, the organic material that constitutes the supporting layer may be a crosslinked polymer or a non-crosslinked polymer.

The multi-layer polishing pad may be provided with only one supporting layer or two or more layers. In addition, the supporting layer and the polishing layer may be directly laminated or may be laminated through another layer. Furthermore, the supporting layer may be adhered to the polishing layer or other layer with an adhesive, an adhesive material (adhesive tape and the like) and the like, or may be integrally bonded thereto by partially fusing.

The present polishing pad and the multi-layer polishing pad may be provided with a hole, a window and the like for endpoint detection.

### BRIEF DESCRIPTION OF THE DRAWINGS

Fig. 1 is a schematic plan view showing one example of a polishing pad of the invention.
Fig. 2 is a schematic plan view showing another example of a polishing pad of the invention.
Fig. 3 is a schematic diagram of a partial cross section including a groove of the polishing pad of the invention.

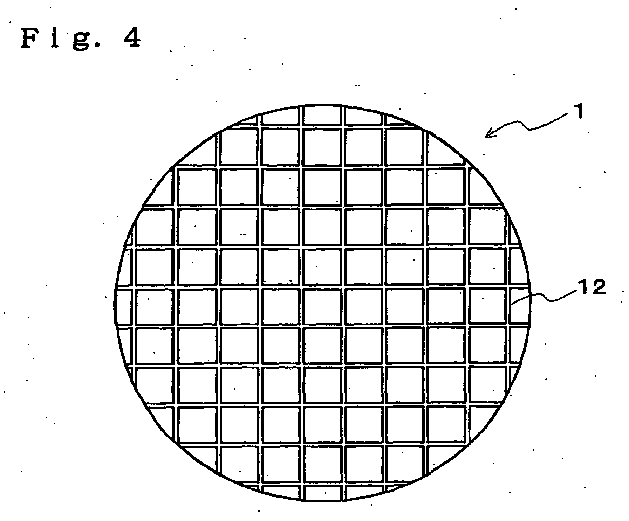

Fig. 4 is a schematic plan view showing another example of a polishing pad of the invention.

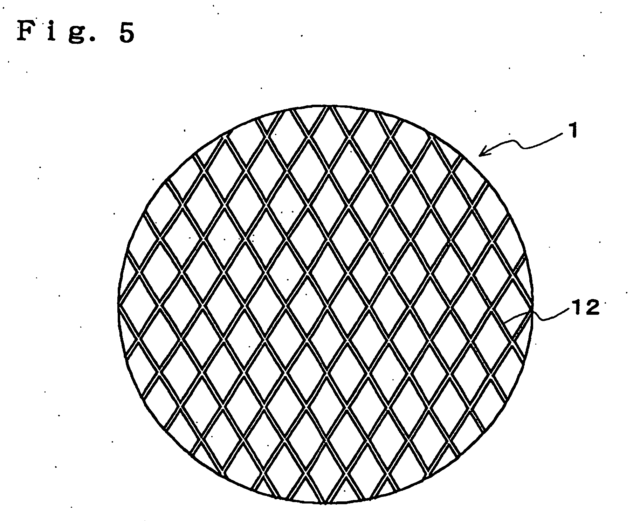

Fig. 5 is a schematic plan view showing another example of a polishing pad of the invention.

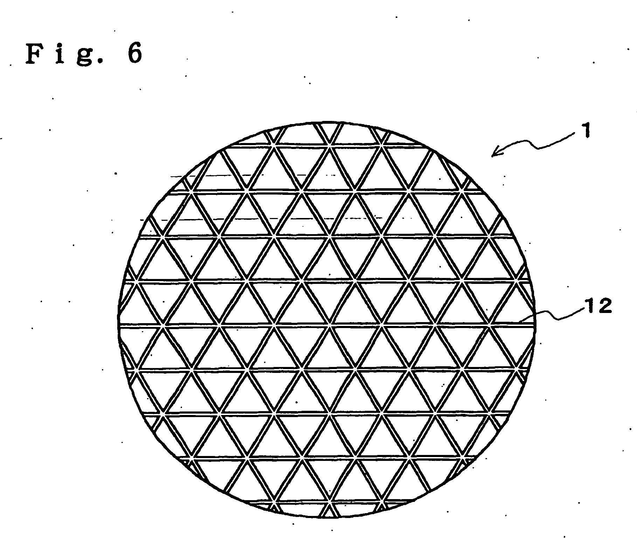

Fig. 6 is a schematic plan view showing another example of a polishing pad of the invention.
Fig. 7 is a schematic plan view showing another example of a polishing pad of the invention.
Fig. 8 is a schematic plan view showing another example of a polishing pad of the invention.
Fig. 9 is a schematic plan view showing another example of a polishing pad of the invention.
Fig. 10 is a schematic diagram of a partial cross section including a concave portion of the polishing pad of the invention.

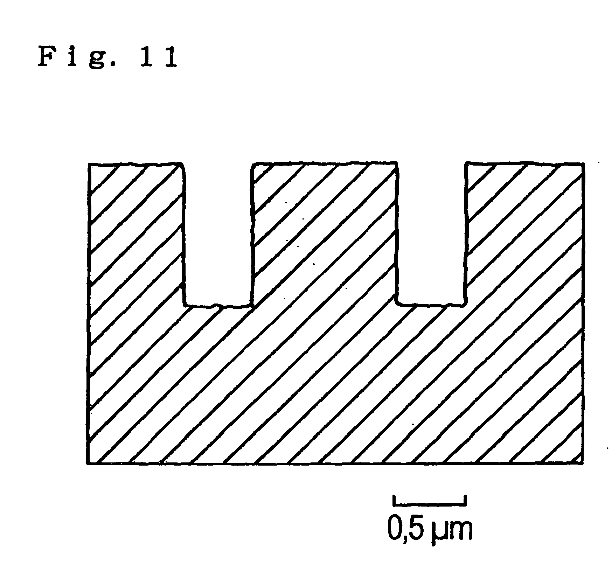

Fig. 11 is an explanatory diagram due to a micrograph image of a partial section of the polishing pad according to Example 1-1.

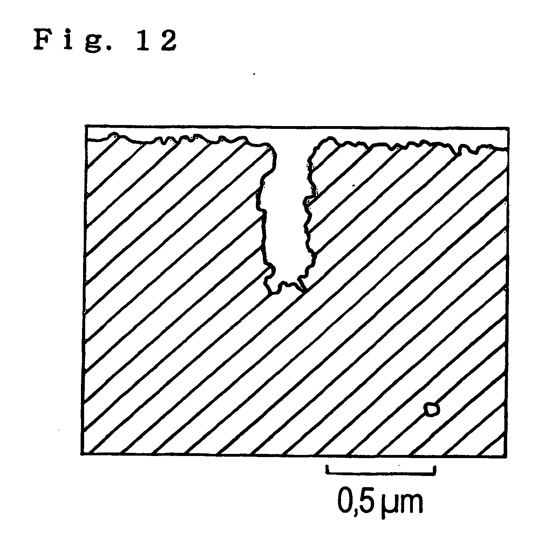

Fig. 12 is an explanatory diagram due to a micrograph image of a partial section of the polishing pad according to a Comparative example 1-1.

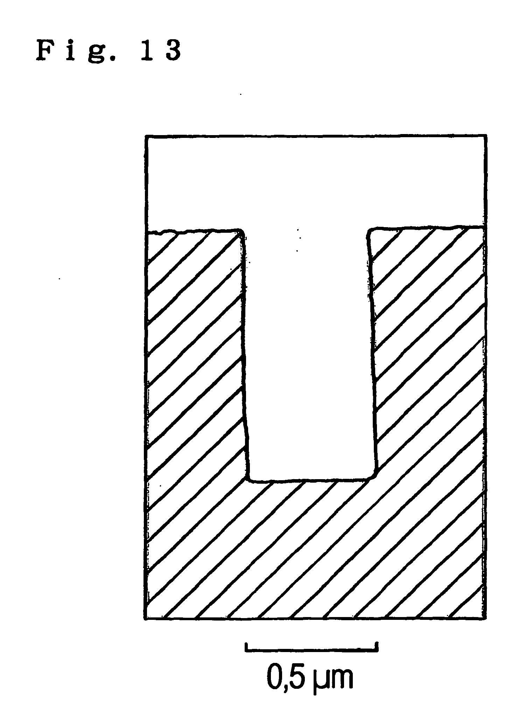

Fig. 13 is an explanatory diagram due to a micrograph image of a partial section of the polishing pad according to Example 2-1.

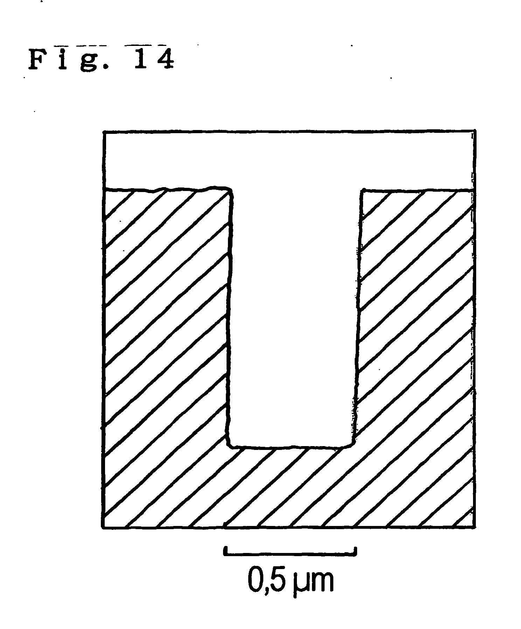

Fig. 14 is an explanatory diagram due to a micrograph image of a partial section of the polishing pad according to Example 3-1.

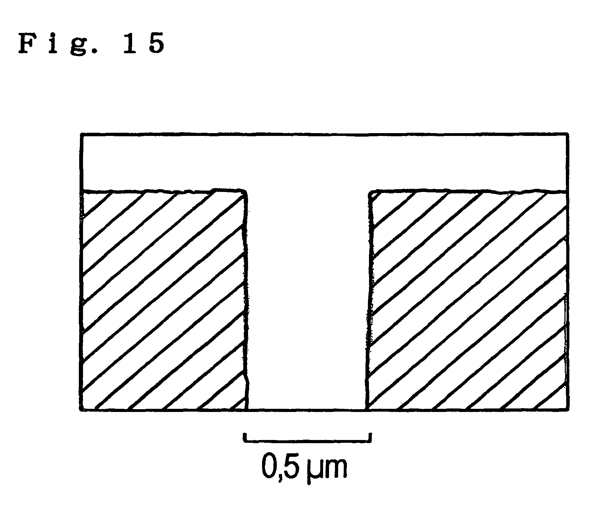

Fig. 15 is an explanatory diagram due to a micrograph image of a partial section of the polishing pad according to Example 4-1.

### EXAMPLE

The present invention is specifically explained below by way of Example.

### [1] Polishing pad having annular groove

### 1-1. Production of polishing pad

### Example 1-1

80 parts by volume of 1,2-polybutadiene (Trade name "JSR RB830" manufactured by JSR Corp.) that becomes a water-insoluble matrix by crosslinking and 20 parts by volume of β-cyclodextrin (Trade name "Dexipearl β-100" manufactured by Bio Research Corporation of Yokohama, average particle diameter; 20 µm) that as a water-soluble particle were kneaded with a screw extruder that is temperature-controlled at 160 °C, and thereby white pellet was obtained. Thereafter, 0.3 parts by volume of organic peroxide (Trade name "Percumyl D-40" manufactured by NOF Corp.) were compounded and further kneaded at 120 °C; the kneaded material was extruded into a die and heated at 170 °C for 18 minutes to crosslink; and thereby a disc-like molded body having a diameter of 60 cm and a thickness of 2.5 mm was obtained. Thereafter, concentric circle-like grooves in which a width is 0.5 mm, a depth is 1 mm, a pitch is 1.5 mm and a length between adjacent grooves is 1 mm shown in Fig. 1 were formed on one surface side of the molded body with a cutting machine manufactured by Kato Kikai Co., Ltd.

In the next place, the surface roughness Ra of an inner surface of the groove was measured in three different view fields with a three-dimensional surface structure analytic microscope (Trade name "Zygo New View 5032" manufactured by CANON Inc.). As a result, the surface roughness Ra was 1.8 µm.

A section of a part of the groove for the polishing pad was enlarged and observed with an optical microscope. The obtained micrograph image is shown in Fig. 11.

### Example 1-2

100 parts by volume of 1,2-polybutadiene (Trade name "JSR RB840" manufactured by JSR Corp.) that becomes a water-insoluble matrix by crosslinking and 100 parts by volume of a water-soluble particle (average particle diameter: 20 µm) obtained by coating polypeptide on β-cyclodextrin (Trade name "Dexipearl β-100" manufactured by Bio Research Corporation of Yokohama) were kneaded with a screw extruder that is temperature-controlled at 160 °C, and thereby white pellet was obtained. Thereafter, 0.3 parts by volume of organic peroxide (Trade name "Perhexine 25B" manufactured by NOF Corp.) were compounded with the white pellet and further kneaded at 120 °C, and thereby white pellet was obtained. In the next place, the organic peroxide-added white pellet was introduced into a die and heated at 190 °C for 10 minutes to crosslink; and thereby a disc-like molded body having a diameter of 60 cm and a thickness of 2.5 mm was obtained. Thereafter, on one surface side of the molded body, concentric circle-like grooves in which a width is 0.5 mm, a depth is 0.5 mm, a pitch is 1.2 mm and a length between adjacent grooves is 0.7 mm were formed with a cutting machine similar to Example 1-1.

Next, the surface roughness Ra of an inner surface of the groove was measured similarly to Example 1-1. As a result, the surface roughness Ra was 1.5 µm.

### Comparative example 1-1

The surface roughness Ra of an inner surface of a groove for a polishing pad made of foamed polyurethane having an annular groove that has a width of 0.25 mm, a depth of 0.4 mm and a pitch of 1.5 mm (Trade name "IC1000" manufactured by Rodel Nitta Co.) was measured similarly to Example 1-1. As a result, the surface roughness Ra was 30 µm.

In addition, a section of a part of the groove for the polishing pad was enlarged and observed with an optical microscope. The obtained micrograph image is shown in Fig. 12.

### 1-2. Evaluation of polishing performance

The polishing pads according to Examples 1-1 and 1-2 and Comparative example 1-1 each were mounted on a surface plate of polishing apparatus (Trade name "Lap Master LM-15" manufactured by SFT Corp.) and SiO₂ film wafers were polished for two minutes under the conditions of the number of revolution of 50 rpm and a flow rate of 100 cc/min of a chemical mechanical polishing slurry (Trade name "CMS 1101" manufactured by JSR Corp.) that was diluted to three times. The polishing pads each were evaluated of the removal rate, scratches, foreign matters and state of pores. The respective measurement methods were performed as follows.
(1) Removal rate; Thicknesses before and after polishing were measured with an optical thickness meter and a removal rate was calculated from these thicknesses.
(2) Scratch and foreign matters; Polished surfaces of the SiO₂ film wafers after polishing were observed with an electron microscope.
   The evaluation criteria of the scratch were as follows; that is, O; no scratch was observed, ×; scratch was observed. And the evaluation criteria of the foreign matters was as follows; that is, O; no foreign matter was observed, ×; foreign matter was observed.
(3) State of pores: A surface of each of the polishing pads was polished for 5 minutes with #400 diamond abrasive followed by dressing, and thereafter, a state of pores on a dressed surface was observed with an electron microscope.

The evaluation criteria were as follows; that is, O; practically all pores were opened, ×; pores were partially clogged.

Results of (1) through (3) are together shown in Table 1.

**Table 1**

| | Surface roughness Ra (µm) | Removal rate (mn/min) | Scratch | Foreign matters | State of pores |
|---|---|---|---|---|---|
| Example 1-1 | 1.8 | 200 | ○ | ○ | ○ |
| Example 1-2 | 1.5 | 250 | ○ | ○ | ○ |
| Comparative example 1-1 | 30 | 50 | × | × | × |

From measurement results of the surface roughness, it is found that the groove of the polishing pad according to Comparative example 1-1 is large in the unevenness of an inner surface, namely non-uniform. In addition, according to Fig. 12, a large projection is observed. Furthermore, Fig. 3.63 in Detailed Semiconductor CMP Technology, ed. Doi Toshirou (Kogyo Chosakai, first printing), pp. 114 is a scanning electron micrograph of a foamed polyurethane polishing pad (Trade name "IC1000" manufactured by Rodel Nitta Co.) similar to the polishing pad used in Comparative example 1-1. Also from this micrograph, it is found that there is larger unevenness in the groove in comparison with Fig. 11 due to Example 1-1.

From results in Table 1, the scratches and foreign matters were observed on the polished surface polished with the polishing pad according to Comparative example 1-1. In addition, the pores after dressing were partially clogged, that is, closed.

In particular, almost all of the pores in the surroundings of the opening portion of the groove that is likely to be clogged by dressing were clogged. Furthermore, it is found that the removal rate of the Comparative example 1-1 was one fourth that of Example 1-1 and one fifth that of Example 1-2, that is, largely inferior to these. This is considered because the pores were clogged with foreign matters and the like during polishing.

On the other hand, in the polishing pads according to Examples 1-1 and 1-2, a side surface and a bottom surface inside of the groove were very small in the surface roughness, that is, smooth. This can be confirmed from Fig. 11. Accordingly, the scratches and the foreign matters were hardly observed on the polished surface. Furthermore, almost all of the pores were completely opened even after dressing, and all of the pores in the surroundings of the opening of the groove were opened in particular. The removal rate relative to that of Comparative example 1-1 was 4 times for example 1-1 and 5 times for Example 1-2. This is considered because the pores were not clogged owing to the foreign matters.

### [2] Polishing pad having lattice-like groove

### 2-1. Production of polishing pad

### Example 2-1

On one surface side of the disc-like molded body that was obtained in Example 1-1 and had a diameter of 60 cm and a thickness of 2.5 mm, lattice-like grooves in which a width is 0.5 mm, a depth is 1 mm, a longitudinal pitch is 5 mm and a transverse pitch is 5 mm, and a planar shape of one pattern that forms a lattice is a square shown in Fig.4 were formed with a cutting machine manufactured by Kato Kikai Co., Ltd.

In the next place, from the obtained polishing pad, a slice for use in surface roughness measurement was cut so that a groove might be included in a width direction. Thereafter, the surface roughness Ra of an inner surface of the groove was measured in three different view fields of the slice with the above-mentioned three-dimensional surface structure analytic microscope. As a result, the surface roughness Ra was 2.5 µm.

A section of a part of the groove for the polishing pad was enlarged and observed with an optical microscope. The obtained micrograph image is shown in Fig. 13.

### Example 2-2

On one surface side of the disc-like molded body that was obtained in Example 1-2 and had a diameter of 60 cm and a thickness of 2.5 mm, with a cutting machine similar to Example 2-1, lattice-like grooves in which a width is 1 mm, a depth is 1 mm, a longitudinal pitch is 10 mm and a transverse pitch is 10 mm, and a planar shape of one pattern that forms a lattice is a square were formed.

In the next place, the surface roughness Ra of an inner surface of the groove were measured similarly to Example 2-1. As a result, the surface roughness Ra was 2.2 µm

### Comparative example 2-1

The-surface roughness Ra of an inner surface of a groove of a polishing pad made of foamed polyurethane having a lattice-like groove that has a width of 2 mm, a depth of 0.5 mm, a longitudinal pitch of 15 mm and a transverse pitch of 15 mm (Trade name "IC1000" manufactured by Rodel Nitta Co.) were measured similarly to Example 2-1. As a result, the surface roughness Ra was 25 µm.

### 2-2. Evaluation of polishing performance

Similarly to the [1], the polishing characteristics of the polishing pads according to Examples 2-1 and 2-2 and Comparative example 2-1 were evaluated. Results are shown in Table 2.

**Table 2**

| | Surface roughness Ra (µm) | Removal rate (nm/min) | Scratch | Foreign matters | State of pores |
|---|---|---|---|---|---|
| Example 2-1 | 2.5 | 180 | ○ | ○ | ○ |
| Example 2-2 | 2.2 | 135 | ○ | ○ | ○ |
| Comparative example 2-1 | 25 | 45 | × | × | × |

From measurement results of the surface roughness, it is found that the groove of the polishing pad according to Comparative example 1-1 is large in the unevenness of an inner surface, namely non-uniform. In addition, Fig. 3.63 in Detailed Semiconductor CMP Technology, ed. Doi Toshirou (Kogyo Chosakai, first printing), pp. 114 is a scanning electron micrograph of a foamed polyurethane polishing pad (Trade name "IC1000" manufactured by Rodel Nitta Co.) similar to the polishing pad used in Comparative example 1-1. Also from this micrograph, it is found that there is larger unevenness in the groove in comparison with Fig. 13 due to Example 2-1.

From results in Table 2, the scratches and foreign matters were observed on the polished surface polished with the polishing pad according to Comparative example 2-1. In addition, the pores after dressing were partially clogged, that is, closed. In particular, almost all of the pores in the surroundings of the opening portion of the groove that is likely to be clogged by dressing were clogged. Furthermore, it is found that the removal rate of the Comparative example 2-1 was one fourth that of Example 2-1 and one third that of Example 2-2, that is, largely inferior to these. This is considered because the pores were clogged with foreign matters and the like during polishing.

On the other hand, in the polishing pads according to Examples 2-1 and 2-2, a side surface and a bottom surface inside of the groove were very small in the surface roughness, that is, smooth. This can be confirmed from Fig. 13. Accordingly, the scratches and the foreign matters were hardly observed on the polished surface. Furthermore, almost all of the pores were completely opened even after dressing, and all of the pores in the surroundings of the opening of the groove were opened in particular. The removal rate relative to that of Comparative example 2-1 was 4 times for example 2-1 and 3 times for Example 2-2. This is considered because the pores were not clogged owing to the foreign matters.

### [3] Polishing pad having spiral groove

### 3-1. Production of polishing pad

### Example 3-1

On one surface side of the disc-like molded body that was obtained in Example 1-1 and had a diameter of 60 cm and a thickness of 2.5 mm, spiral grooves in which a width is 1 mm, a depth is 1 mm, a pitch is 2.5 mm and a length between adjacent grooves is 1.5 mm shown in Fig.7 were formed with a cutting machine manufactured by Kato Kikai Co., Ltd.

In the next place, from the obtained polishing pad, a slice for use in surface roughness measurement was cut so that a groove might be included in a width direction. Thereafter, the surface roughness Ra of an inner surface of the groove was measured in three different view fields of the slice with the above-mentioned three-dimensional surface structure analytic microscope. As a result, the surface roughness Ra was 2.0 µm.

A section of a part of the groove for the polishing pad was enlarged and observed with an optical microscope. The obtained micrograph image is shown in Fig. 14.

### Example 3-2

On one surface side of the disc-like molded body that was obtained in Example 1-2 and had a diameter of 60 cm and a thickness of 2.5 mm, with a cutting machine similar to Example 3-1, spiral grooves in which a width is 0.5 mm, a depth is 0.5 mm, a pitch of 1.7 mm and a length between adjacent grooves is 1.2 mm were formed.

In the next place, the surface roughness Ra of an inner surface of the groove was measured similarly to Example 3-1. As a result, the surface roughness Ra was 1.9 µm.

### Comparative example 3-1

The surface roughness Ra of an inner surface of a groove of a polishing pad made of foamed polyurethane having a spiral groove that has a width of 0.25 mm, a depth of 0.4 mm, and a pitch of 1.5 mm (Trade name "IC1000" manufactured by Rodel Nitta Co.) was measured similarly to Example 3-1. As a result, the surface roughness Ra was 25 µm.

### 3-2. Evaluation of polishing performance

Similarly to the [1], the polishing characteristics of the polishing pads according to Examples 3-1 and 3-2 and Comparative example 3-1 were evaluated. Results are shown in Table 3.

**Table 3**

| | Surface roughness Ra (µm) | Removal rate (nm/min) | Scratch | Foreign matters | State of pores |
|---|---|---|---|---|---|
| Example 3-1 | 2.0 | 190 | ○ | ○ | ○ |
| Example 3-2 | 1.9 | 260 | ○ | ○ | ○ |
| Comparative example 3-1 | 25 | 50 | × | × | × |

From measurement results of the surface roughness, it is found that the groove of the polishing pad according to Comparative example 3-1 is large in the unevenness of an inner surface, namely non-uniform. In addition, Fig. 3.63 in Detailed Semiconductor CMP Technology, ed. Doi Toshirou (Kogyo Chosakai, first printing), pp. 114 is a scanning electron micrograph of a foamed polyurethane polishing pad (Trade name "IC1000" manufactured by Rodel Nitta Co. has a groove on polishing surface side) similar to the polishing pad used in Comparative example 3-1. Also from this micrograph, it is found that there is larger unevenness in the groove in comparison with Fig. 14 due to Example 3-1.

From results in Table 3, -the scratches and foreign matters were observed on the polished surface polished with the polishing pad according to Comparative example 3-1. In addition, the pores after dressing were partially clogged, that is, closed. In particular, almost all of the pores in the surroundings of the opening portion of the groove that is likely to be clogged by dressing were clogged. Furthermore, it is found that the removal rate of the Comparative example 2-1 was substantially one fourth that of Example 3-1 and substantially one fifth that of Example 3-2, that is, largely inferior to these. This is considered because the pores were clogged with foreign matters and the like during polishing.

On the other hand, in the polishing pads according to Examples 3-1 and 3-2, a side surface and a bottom surface inside of the groove were very small in the surface roughness, that is, smooth. This can be confirmed from Fig. 14. Accordingly, the scratches and the foreign matters were hardly observed on the polished surface. Furthermore, almost all of the pores were completely opened even after dressing, and all of the pores in the surroundings of the opening of the groove were opened in particular. The removal rate relative to that of Comparative example 3-1 was nearly 4 times for example 3-1 and so large as more than 5 times for Example 3-2. This is considered because the pores were not clogged owing to the foreign matters.

### [4] Polishing pad having concave portion

### 4-1. Production of polishing pad

### Example 4-1

On one surface side of the disc-like molded body that was obtained in Example 1-1 and had a diameter of 60 cm and a thickness of 2.5 mm, many concave portions whose planar shape is a circle, diameter is 0.5 mm, depth is 1 mm, and pitch is 1.5 mm [distances between the respective concave portions in a circumferential direction and in a diametrical direction were the same (1 mm), respectively; that is, these concave portions were disposed equidistant.] shown in Fig.9 were formed with a cutting machine manufactured by Kato Kikai Co., Ltd.

In the next place, from the obtained polishing pad, a slice for use in surface roughness measurement was cut out so that a section of a plurality of concave portions might be included. Thereafter, the surface roughness Ra of an inner surface of the groove was measured in three different view fields of the slice with the above-mentioned three-dimensional surface structure analytic microscope. As a result, the surface roughness Ra was 2.3 µm.

A section of a part of the concave portion for the polishing pad was enlarged and observed with an optical microscope. The obtained micrograph image is shown in Fig. 15.

### Example 4-2

On one surface side of the disc-like molded body that was obtained in Example 1-2 and had a diameter of 60 cm and a thickness of 2.5 mm, with a cutting machine similar to Example 3-1, many concave portions whose planar shape is a circle, diameter is 0.5 mm, depth is 0.5 mm, and pitch is 1.2 mm [distances between the respective concave portions in a circumferential direction and in a diametrical direction were the same (0.7 mm), respectively; that is, these concave portions were disposed equidistant.] were formed.

In the next place, the surface roughness Ra of an inner surface of the concave portion was measured similarly to Example 4-1. As a result, the surface roughness Ra was 1.5 µm.

### Comparative example 4-1

The surface roughness Ra of an inner surface of a concave portion of a polishing pad made of foamed polyurethane having many concave portions whose diameter is 1.5 mm, depth is 1.0 mm and pitch is 5.5 mm (Trade name "IC1000" manufactured by Rodel Nitta Co.) was measured similarly to Example 4-1. As a result, the surface roughness Ra was 25 µm.

### 4-2. Evaluation of polishing performance

Similarly to the [1], the polishing characteristics of the polishing pads according to Examples 4-1 and 4-2 and Comparative example 4-1 were evaluated. Results are shown in Table 4.

**Table 4**

| | Surface roughness Ra (µm) | Removal rate (nm/min) | Scratch | Foreign matters | State of pores |
|---|---|---|---|---|---|
| Example 4-1 | 2.3 | 210 | ○ | ○ | ○ |
| Example 4-2 | 1.5 | 260 | ○ | ○ | ○ |
| Comparative example 4-1 | 2.5 | 50 | × | × | × |

From measurement results of the surface roughness, it is found that the groove of the polishing pad according to Comparative example 4-1 is large in the unevenness of an inner surface, namely non-uniform. In addition, Fig. 3.63 in Detailed Semiconductor CMP Technology, ed. Doi Toshirou (Kogyo Chosakai, first printing), pp. 114 is a scanning electron micrograph of a foamed polyurethane polishing pad (Trade name "IC1000 " manufactured by Rodel Nitta Co. has a groove on polishing surface side) similar to the polishing pad used in Comparative example 4-1. Also from this micrograph, it is found that there is larger unevenness in the concave portion in comparison with Fig. 15 due to Example 4-1.

From results in Table 4, the scratches and foreign matters were observed on the polished surface polished with the polishing pad according to Comparative example 4-1. In addition, the pores after dressing were partially clogged, that is, closed. In particular, almost all of the pores in the surroundings of the opening portion of the concave portion that is likely to be clogged by dressing were clogged. Furthermore, it is found that the removal rate of the Comparative example 4-1 was substantially one fourth that of Example 4-1 and substantially one fifth that of Example 4-2, that is, largely inferior to these. This is considered because the pores were clogged with foreign matters and the like during polishing.

On the other hand, in the polishing pads according to Examples 4-1 and 4-2, a side surface and a bottom surface inside of the concave portion were very small in the surface roughness, that is, smooth. This can be confirmed from Fig. 15. Accordingly, the scratches and the foreign matters were hardly observed on the polished surface. Furthermore, almost all of the pores were completely opened even after dressing, and all of the pores in the surroundings of the opening of the concave portion were opened in particular. The removal rate relative to that of Comparative example 4-1 was nearly 4 times for example 4-1 and so large as more than 5 times for Example 4-2. This is considered because the pores were not clogged owing to the foreign matters.

The present invention intends to provide a polishing pad and according to an embodiment a multi-layer polishing pad that can particularly effectively suppress scratch from occurring. The polishing pad of the invention comprises at least one part selected from a groove (a) having at least one kind of shape selected from annular, lattice-like and spiral form on a polishing surface side, a concave portion (b) and a through hole (c). In the above, surface roughness of an inner surface of the part is 20 µm or less and the polishing pad is used for chemical mechanical polishing.

## Claims

1. A Polishing pad comprising:
at least one part selected from the group consisting of a groove (a) having at least one kind of shape selected from annular, lattice-like and spiral form on a polishing surface side, a concave portion (b) and a through hole (c);
**characterized in that** a surface roughness of the inner surface of said part is 20 µm or less.

2. The polishing pad according to Claim 1, wherein a depth of said groove (a) is 0.1 mm or more and a width thereof is 0.1 mm or more.

3. The polishing pad according to Claim 1 or 2, wherein said groove (a) is formed concentrically.

4. The polishing pad according to any one of Claims 1 to 3, wherein a depth of said concave portion (b) is 0.1 mm or more, and a minimum length of an opening thereof is 0.1 mm or more.

5. The polishing pad according to any one of Claims 1 to 4, wherein a minimum length of an opening of said through hole (c) is 0.1 mm or more.

6. The polishing pad according to any one of Claims 1 to 5, wherein an area of an opening of each of said concave portion (b) and said through hole (c) is 0.0075 mm² or more.

7. The polishing pad according to any one of Claims to 6, wherein a minimum length between adjacent openings of each of said groove (a), said concave portion (b) and said through hole (c) is 0.05 mm or more.

8. The polishing pad according to any one of Claims 1 to 7, wherein at least part of said polishing pad comprises a water-insoluble matrix that contains a crosslinked polymer and a water-soluble particle dispersed in said water-insoluble matrix.

9. The polishing pad according to any one of claims 1 to 8, **characterized by** a polishing layer comprising said at least one part and a supporting layer laminated on a non-polishing surface side of said polishing layer.

10. A process for manufacturing a polishing pad comprising:
a step for moulding a desired rough shape of a composition for polishing pad, and
a step for cutting a moulded body to form at least one part selected from the group consisting of a groove (a) having at least one kind of shape selected from annular, lattice-like and spiral form on a polishing surface side, a concave portion (b) and a through hole (c), **characterized in that**
the inner surface of said part is 20 µm or less in surface roughness.

11. A process for manufacturing a polishing pad comprising a step for die moulding by using a composition for polishing pad to form a polishing pad having at least one part selected from the group consisting of a groove (a) having at least one kind of shape selected from annular, lattice-like and spiral form on a polishing surface side, a concave portion (b) and a through hole (c), **characterized in that**
the inner surface of said part is 20 µm or less in surface roughness.

12. The process for manufacturing a polishing pad according to claim 10 or 11,
wherein said composition for polishing pad comprises a water-insoluble matrix that contains a crosslinked polymer and a water-soluble particle dispersed in said water-insoluble matrix.

## Patentansprüche

1. Polierkissen aufweisend:
Zumindest eine Komponente ausgewählt aus der Gruppe, die aus einer Rille (a), die zumindest eine Art der Form aufweist, die aus ringförmig, gitterähnlich und einer Spiralform ausgewählt wird, auf einer Seite der Polieroberfläche, einem konkaven Teil (b) und einem durchgehenden Loch (c) besteht, **dadurch gekennzeichnet, dass** die Oberflächenrauheit der inneren Oberfläche von dieser Komponente 20 µm oder weniger beträgt.

2. Polierkissen nach Anspruch 1, wobei die Tiefe der Rille (a) 0,1 mm oder mehr beträgt und ihre Breite 0,1 mm oder mehr beträgt.

3. Polierkissen nach Anspruch 1 oder 2, wobei die Rille (a) konzentrisch ausgebildet ist.

4. Polierkissen nach irgendeinem der Ansprüche 1 bis 3, wobei eine Tiefe des konkaven Teils (b) 0,1 mm oder mehr und eine Mindestlänge einer Öffnung davon 0,1 mm oder mehr beträgt.

5. Polierkissen nach irgendeinem der Ansprüche 1 bis 4, wobei eine Mindestlänge von einer Öffnung von dem durchgehenden Loch (c) 0,1 mm oder mehr beträgt.

6. Polierkissen nach irgendeinem der Ansprüche 1 bis 5, wobei die Fläche einer Öffnung von jedem konkaven Teil (b) und dem durchgehenden Loch (c) 0,0075 mm² oder mehr beträgt.

7. Polierkissen nach irgendeinem der Ansprüche 1 bis 6, wobei eine Mindestlänge zwischen benachbarten Öffnungen von jeder Rille (a), dem konkaven Teil (b) und dem durchgehenden Loch (c) 0,05 mm oder mehr beträgt.

8. Polierkissen nach irgendeinem der Ansprüche 1 bis 7, wobei zumindest ein Teil des Polierkissens eine wasserunlösliche Matrix aufweist, die ein vernetztes Polymer und ein wasserlösliches Teilchen, dispergiert in der wasserunlöslichen Matrix, enthält.

9. Polierkissen nach irgendeinem der Ansprüche 1 bis 8, **gekennzeichnet, durch** eine Polierschicht, die zumindest eine Komponente und eine Trägerschicht aufweist, die auf einer nicht polierenden Oberflächenseite der Polierschicht laminiert ist.

10. Verfahren zu Herstellung eines Polierkissens aufweisend:
Einen Schritt zur Bildung einer gewünschten rohen Form einer Anordnung für ein Polierkissen und einen Schritt zum Schneiden eines geformten Körpers, um zumindest eine Komponente, ausgewählt aus der Gruppe, die aus einer Rille (a), die zumindest eine Art der Form aufweist, die aus ringförmig, gitterähnlich und einer Spiralform ausgewählt wird, auf einer Seite der Polieroberfläche, einem konkaven Teil (b) und einem durchgehenden Loch (c) besteht, zu bilden, **dadurch gekennzeichnet, dass** die innere Oberfläche von diesem Teil 20 µm oder weniger bei der Oberflächenrauheit beträgt.

11. Verfahren zu Herstellung eines Polierkissens aufweisend:
Einen Schritt des Spritzgießens, indem eine Anordnung für ein Polierkissen verwendet wird, um ein Polierkissen zu bilden, das zumindest eine Komponente aufweist, die aus der Gruppe ausgewählt wird, die aus einer Rille (a), die zumindest eine Art der Form aufweist, die aus ringförmig, gitterähnlich und einer Spiralform ausgewählt wird, auf einer Seite der Polieroberfläche, einem konkaven Teil (b) und einem durchgehenden Loch (c) besteht, **dadurch gekennzeichnet, dass** die innere Oberfläche von diesem Teil 20 µm oder weniger bei der Oberflächenrauheit beträgt.

12. Verfahren zu Herstellung eines Polierkissens nach Anspruch 10 oder 11, wobei die Anordnung für das Polierkissen eine wasserunlösliche Matrix aufweist, die ein vernetztes Polymer und ein wasserlösliches Teilchen, dispergiert in der wasserunlöslichen Matrix, enthält.

## Revendications

1. Tampon de polissage comprenant :
au moins une partie sélectionnée à partir du groupe constitué d'une rainure (a) ayant au moins un type de forme sélectionnée à partir d'une forme annulaire, une forme semblable à un treillis, et une forme de spirale à partir d'un côté de surface de polissage, une partie concave (b) et un trou traversant (c),
**caractérisé en ce qu'**une rugosité de surface de la surface intérieure de ladite partie est de 20 µm ou moins.

2. Tampon de polissage selon la revendication 1, dans lequel la profondeur de ladite rainure (a) est de 0,1 mm ou plus et sa largeur est de 0,1 mm ou plus.

3. Tampon de polissage selon la revendication 1 ou 2, dans lequel ladite rainure (a) est formée de façon concentrique.

4. Tampon de polissage selon l'une quelconque des revendications 1 à 3, dans lequel la profondeur de ladite partie concave (b) est de 0,1 mm ou plus, et une longueur minimum d'une ouverture de celle-ci est de 0,1 mm ou plus.

5. Tampon de polissage selon l'une quelconque des revendications 1 à 4, dans lequel une longueur minimum d'une ouverture dudit trou traversant (c) est de 0,1 mm ou plus.

6. Tampon de polissage selon l'une quelconque des revendications 1 à 5, dans lequel une surface d'une ouverture de chacune de ladite partie concave (b) et dudit trou traversant (c) est de 0,0075 mm² ou plus.

7. Tampon de polissage selon l'une quelconque des revendications 1 à 6, dans lequel une longueur minimum entre des ouvertures adjacentes de chacun de ladite rainure (a), de ladite partie concave (b) et dudit trou traversant (c) est de 0,05 mm ou plus.

8. Tampon de polissage selon l'une quelconque des revendications 1 à 7, dans lequel au moins une partie dudit tampon de polissage comprend une matrice insoluble dans l'eau qui contient un polymère réticulé et une particule soluble dans l'eau dispersée dans ladite matrice insoluble dans l'eau.

9. Tampon de polissage selon l'une quelconque des revendications 1 à 8, **caractérisé par** une couche de polissage comprenant ladite au moins une partie et une couche de support stratifiée sur un côté de surface de non polissage de ladite couche de polissage.

10. Procédé de fabrication d'un tampon de polissage comprenant :
une étape de moulage d'une forme grossière souhaitée d'une composition pour un tampon de polissage, et
une étape de découpe d'un corps moulé pour former au moins une partie sélectionnée à partir du groupe constitué d'une rainure (a) ayant au moins un type de forme sélectionné à partir d'une forme annulaire, d'une forme semblable à un treillis et une forme de spirale sur un côté de surface de polissage, une partie concave (b) et un trou traversant (c), **caractérisé en ce que** la surface intérieure de ladite partie présente une rugosité de surface de 20 µm ou moins.

11. Procédé de fabrication d'un tampon de polissage comprenant une étape de moulage sous pression en utilisant une composition pour tampon de polissage afin de former un tampon de polissage ayant au moins une partie sélectionnée parmi le groupe constitué d'une rainure (a) ayant au moins un type de forme sélectionné à partir d'une forme annulaire, une forme semblable à un treillis et une forme de spirale sur un côté de surface de polissage, une partie concave (b) et un trou traversant (c), **caractérisé en ce que** la surface intérieure de ladite partie présente une rugosité de surface de 20 µm ou moins.

12. Procédé de fabrication d'un tampon de polissage conforme à la revendication 10 ou 11,
dans lequel ladite composition pour le tampon de polissage comprend une matrice insoluble dans l'eau qui contient un polymère réticulé et une particule soluble dans l'eau dispersée dans la matrice insoluble dans l'eau.
